# EUROPEAN PATENT SPECIFICATION

(11) **EP 2 780 995 B1**
(45) Date of publication and mention of the grant of the patent: **07.11.2018**
(21) Application number: 12798951.5
(22) Date of filing: 14.11.2012
(51) Int. Cl.: H02H 3/24, H02H 3/46, H02J 3/14, H02J 13/00, G01D 4/00

(54) **ELECTRICAL POWER DISTRIBUTION SYSTEMS, SMART ELECTRICITY METERS, AND METHODS OF CONTROLLING LOCAL POWER CONNECTION**
STROMVERTEILUNGSSYSTEME, INTELLIGENTE STROMZÄHLER UND VERFAHREN ZUR STEUERUNG EINES LOKALEN STROMANSCHLUSSES
SYSTÈMES DE DISTRIBUTION D'ÉLECTRICITÉ, COMPTEURS ÉLECTRIQUES INTELLIGENTS ET PROCÉDÉS DE COMMANDE DE LA CONNEXION AU RÉSEAU LOCAL

(30) Priority: 14.11.2011 US 201161629063 P; 13.11.2012 US 201213675137
(43) Date of publication of application: 24.09.2014
(73) Proprietor: Emeter Corporation, San Mateo, California 94404 (US)
(72) Inventor: KING, Christopher Slaboszewicz, Berkeley, CA 94707 (US); JOHNSON, Larsh Maur, La Jolla, CA 92037 (US)
(74) Representative: Maier, Daniel Oliver
(86) International application number: PCT/US2012/064977
(87) International publication number: WO 2013/074602

(56) References cited:
- EP-A1- 0 044 181
- WO-A1-03/014748
- US-A- 2 292 935
- US-A1- 2005 001 486
- US-A1- 2005 134 430
- US-A1- 2006 077 605
- US-A1- 2006 221 521
- US-A1- 2008 258 709
- US-A1- 2010 007 522
- US-A1- 2011 106 327

## Description

### RELATED APPLICATIONS

This application claims priority to US Provisional Patent Application Serial Number 61/629,063 filed on November 14, 2012, entitled "SYSTEM FOR SMART METER-SMART BREAKER," the disclosure of which is hereby incorporated by reference in its entirety herein.

### FIELD

The present invention relates generally to electrical power systems having electricity meters, and more particularly to electricity meters having a remotely-activated service disconnect switch.

### BACKGROUND

Traditionally, end users have simply received electricity from their providers via the utility power distribution grid. More recently, end users have begun installing their own customer-site electrical power generators, such as photovoltaic panels, wind turbines, gas-powered generators, as well as their own customer-site electrical storage devices (e.g., batteries). These developments create the opportunity for the end user to utilize customer-site generation or storage as back-up power in the event of a power outage, when the normal electricity provider's supply is interrupted.

However, utilizing customer-site electrical generators or electrical storage devices for such backup can create unsafe power feeds back onto the utility distribution grid, for example energizing lines that utility crews are in the process of restoring. To prevent such unsafe feeds, the customer-site electrical circuits must be isolated from the power distribution grid while using customer-site generation or storage for backup power.

Electrical utility service providers such as electrical utilities deliver electricity to the end users through an electricity meter. Electricity meters track the amount of energy consumed by the customer, typically measured in kilowatt-hours ("kwh"), at each customer's location. The electrical utility service providers may use the consumption information primarily for billing, but also for resource allocation, planning, and other purposes.

More recently, many utilities have begun installing smart electricity meters that have the ability to communicate bi-directionally between the electricity meter and the utility data center. Many of these electricity meters have an internal service disconnect switch that can be used to disconnect the customer's load remotely, via a control signal sent by the communications network to the electricity meter. Many of these smart electricity meters also have a communications device to send signals into the customer's premise via a home area network (HAN). These signals, when displayed on an in-home display, for example, can show customers how much electricity they are using in real time, thus enabling them to manage their usage better. Today, remote disconnection of a load at an electricity meter may be performed either manually, or via an automated software application, initiating a disconnect control signal at the computer server that is at the "head end" of a communications network connected to the electricity meter. The disconnect signal is sent over the communications network, received by the electricity meter, and then disconnects the power. Reconnection occurs in a similar fashion via receipt of a reconnect signal. Such disconnections may be performed for non-payment of a utility bill and for changes in customer or electricity supplier at the customer location.

An electrical power distribution system of this type is known from US2010/007522.

### SUMMARY

In a first aspect, an electrical power distribution system as defined in claim 1 is provided.

In another aspect, an electricity meter as defined in claim 15 is provided.

In a method aspect as defined in claim 16, a method of controlling electricity power connection is provided. The method includes providing an electricity meter the electricity meter having a meter housing containing a communications module configured to receive one or more thresholds, a memory adapted to store the one or more thresholds, a sensor adapted to measure a parameter of the power lines, a processor adapted to compare the parameter or a value derived therefrom to the one or more thresholds, and a service disconnect switch; and automatically opening the service disconnect switch if the parameter or the value derived therefrom fails to meet conditions established by the one or more thresholds.

Still other aspects, features, and advantages of the present invention may be readily apparent from the following detailed description by illustrating a number of example embodiments and implementations, including the best mode contemplated for carrying out the present invention. The present invention may also be capable of other and different embodiments, and its several details may be modified in various respects, all without departing from the scope of the present invention. Accordingly, the drawings and descriptions are to be regarded as illustrative in nature, and not as restrictive. The invention is to cover all modifications, equivalents, and alternatives falling within the scope of the invention, as defined by the appended claims.

### BRIEF DESCRIPTION OF THE DRAWINGS

FIG. 1 illustrates a block diagram of an electrical power distribution system having an electric meter according to embodiments.
FIG. 2 illustrates a block diagram of an electrical power distribution system having an electric meter and a customer-site electric generator according to embodiments.
FIG. 3 illustrates a block diagram of an electrical power distribution system having an electric meter and a customer-site electric storage device according to embodiments.
FIG. 4 illustrates a block diagram of another electrical power distribution system having an electric meter and a customer-site generator or storage and a home area network (HAN) according to embodiments.
FIG. 5 illustrates a block diagram of a communication and control system that is operative to interface and communicate with an electricity meter according to embodiments.
FIG. 6 illustrates a block diagram of another communication and control system that is operative to interface and communicate with an electricity meter according to embodiments.
FIG. 7 illustrates a block diagram of an electrical power distribution system that is operative to interface and communicate with a plurality of electricity meters according to embodiments.
FIG. 8 illustrates a flowchart of a method of operating an electrical power distribution system according to embodiments.
FIG. 9 illustrates a flowchart of another method of operating an electrical power distribution system according to embodiments.

### DESCRIPTION

Embodiments of the present invention solve two separate but related problems faced by electric utilities or other electricity providers and the end users of electricity. First, embodiments provides a safe method and apparatus configured and adapted to automatically disconnect and isolate the customer's premises from the electrical power distribution grid to enable use of a customer-site electric generator or customer-site electric storage device for backup power during an electrical power outage. Second, one or more embodiments provide a method and apparatus configured and adapted to automatically disconnect customer loads from the electrical power distribution grid when there are voltage or frequency problems on the power lines. Thus, embodiments of the invention may operate to automatically preserve the integrity of the local electrical power distribution grid, as well as the integrity of the electrical network on the line side of the electricity meter. This may prevent a customer's use of customer-site generation or storage, in combination with a utility power outage, from creating a problem potentially affecting many more customers or causing potential safety issues for utility crews.

In accordance with one aspect, an electricity meter is provided that operates to isolate a customer premises to enable the use of customer-site power backup equipment. One embodiment provides automated disconnection based on local sensing by the electricity meter of current, voltage, power, or frequency of the electricity being delivered to the customer via the utility power lines. In accordance with one aspect, an electricity meter is provided that is configured and adapted to communicate with the distribution utility's outage management or other distribution management system so that the isolation can be performed in parallel with the utility's overall operation of the power distribution grid. When the utility's distribution management system is notified of an outage, a control signal may be sent to the electricity meter to disconnect the electricity meter, and, thus isolate the customer's electrical load from the power lines. This enables the customer to operate customer-site generation or on-site storage devices safely as back-up power during the outage.

In another aspect, one or more embodiments the invention are operational to protect the reliability and integrity of the electrical power distribution grid. Traditionally, when there are current, voltage, or frequency problems on an electrical power line, the utility grid operator may disconnect power to the power line via a disconnect device such as a fuse, circuit breaker, or automated switch that is installed on a power distribution feeder or substation. Accordingly, such protection efforts cause power outages that necessarily affect groups of customers rather than individual customers. In addition, problems causing disconnection of one portion of the grid can "cascade," with such disconnect devices causing outages further up the distribution grid, such as at larger substations.

Automatic disconnection of customer loads based on current, voltage, or frequency problems already occurs. For example, Texas has hundreds of large industrial customers with automatic switches to disconnect their loads automatically when the frequency of power on the grid drops below about 59.7 Hz (normal standard is 60 Hz). Customers receive a discount for agreeing to participate.

Already installed smart electricity meters can sense current and, often, voltage and/or frequency, enabling such electricity meters to record consumption, send power outage alerts to utilities, and send voltage data to utilities for use in improving the operation of the distribution grid. Embodiments of the invention may sense the power condition and disconnect power locally. This functionality may be of particular interest with respect to systems including customer-site power generation (e.g., solar photovoltaic generation), because too much such generation installed in a localized area can cause voltage problems for utilities.

Accordingly there is a need for an electrical power distribution system that includes the ability to locally disconnect a customer premises when certain power conditions are met. In particular, the power distribution system may include an electricity meter that includes a service disconnect switch that further includes the capability for automated operation to disconnect and/or reconnect electrical power. Such automatic disconnection and/or reconnection may be based on the electricity meter comparing measured values (e.g., sensed by a sensor and sensor circuit) against preprogrammed thresholds. The preprogrammed thresholds may be current, voltage, power, and/or frequency values. The preprogrammed thresholds may be stored in a memory of the electricity meter. These preprogrammed thresholds may be and synchronized with values stored on a computer database of a communication and control system of a utility's data center. Accordingly, the utility can manage automatic disconnection and/or reconnection schemes centrally and in a coordinated fashion. This may both increase customer satisfaction and increase the amount of electrical load available for automatic disconnection, thus increasing overall power grid reliability.

In addition, one or more embodiments of the present invention may include a capability to isolate the customer's electricity circuits from the power utility distribution grid during power outages so that the customer can use customer-site electricity generator or customer-site electricity storage devices to provide backup power on site. In accordance with this aspect, automated sensing of the condition of the power lines (e.g., determining an outage condition) may involve comparing measured values against one or more threshold parameters defined by thresholds of current, voltage, power, and/or frequency and automated disconnection of the customer circuits via operation of a service disconnection switch of the electricity meter.

In another aspect, automated disconnection and/or connection of the customer-site generator or storage device, coordinated with the disconnection and reconnection provided by the electricity meter, may make the backup easy and convenient for the consumer. Accordingly, in one aspect, the service disconnect switch of the electricity meter is operable locally via preprogrammed instructions stored in memory via the communications network to automatically disconnect and connect the load from the electrical power lines, but may also operate to connect or disconnect a customer-site generator or storage device.

In one embodiment of the invention, an electricity meter is adapted to be coupled to a load, and the load is adapted to be coupled to the electrical power lines. The electricity meter includes one or more sensors and a service disconnect switch. The one or more sensors may be secured in a sensor module having a sensor housing and having one or more voltage, current, power, and/or frequency sensors secured within the sensor housing. Both the sensor module and the service disconnect switch may be secured within a housing of the electricity meter. The one or more sensors are operable to receive voltage and current signals representative of voltage and current provided to the load and generate measurements signals therefrom. The service disconnect switch is operable to automatically disconnect and reconnect the load to the electrical power lines. A memory of the electricity meter stores one or more preprogrammed thresholds for current, voltage, power, or frequency, such that the load is disconnected or reconnected when the conditions set by the one or more thresholds are met or not met. For example, the one or more thresholds may be current, voltage, power, or frequency is within a pre-programmed range. The thresholds are stored in the electricity meter, and are further stored in a computer database devices of a control and communication system residing at a utility data center. Synchronization of the preprogrammed threshold values are maintained via a communications network that is in communication between the electricity meter and a communications server of the control and communication system. In particular, in one or more embodiments, the communications network interfaces with the communications server that is connected a database device storing a database containing the one or more threshold values for the electricity meters. Interface between the communications server and the database device may be through a controls server. The one or more preprogrammed thresholds can also be changed by communicating the changes via the communications network to the electricity meters within the electrical power distribution system.

In one aspect of the invention, an electricity meter is provided that operates to automatically disconnect and/or reconnect an electrical load when conditions set by one or more thresholds are met or not met. In one example, disconnection may occur when a voltage or frequency goes outside of a preprogrammed range. An internal service disconnect switch is operable when actuated to change from a connected state to a disconnected state or vice versa in the event of a reconnection. If there is no power from the power line, the service disconnect switch can be activated via electricity stored in a battery or capacitor.

In accordance with another embodiment of the invention, an electrical power distribution system is provided that includes communications with a customer-site electric generator or a customer-site electric storage device, or both. In this embodiment, the computer storing or interfacing with the database (e.g., the database device) at the communication and control system of the utility data center has the ability to send control signals and information to the customer-site electric generator or a customer-site electric storage device. In one embodiment, the communications may be through the electricity meter. In another embodiment, communication with the communications and control system of the utility data center may be through a connection from the customer-site electric generator or a customer-site electric storage device to a customer-site internet router. The database may contain information about the customer-site electric generator or a customer-site electric storage device to enable proper communication. In addition, the computer functioning as a controls server in the communications and control system of utility data center may be connected to a third computer that functions as a distribution management server in operates outage management or distribution management software.

In one or more embodiments including customer-site electric generator or electric storage device, upon receiving the signal from such computer that a distribution grid outage has occurred, the second computer (e.g., a controls computer) may initiate a signal to disconnect power at the electricity meter and connect power at the customer-site electric generator or electric storage device. When distribution grid power is restored, the controls computer can send a signal to reconnect power at the electricity meter and disconnect the customer-site electric generator or electric storage device. The signal may be provided through the communication module of the electricity meter to the customer-site electric generator or electric storage device, or through a router communicating to the communication module of the electricity meter and the customer-site electric generator or electric storage device secondary communication module.

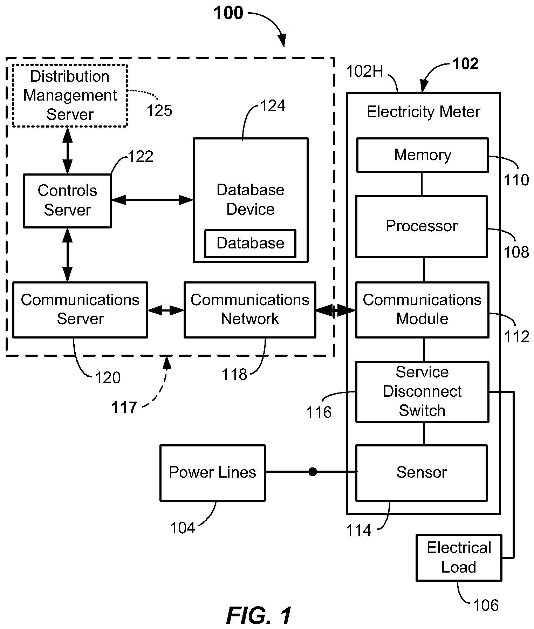

These and other embodiments of the present invention are described with reference to FIGs. 1-9 herein. Now referring to FIG. 1, an electrical power distribution system 100 is shown and described. The electrical power distribution system 100 includes an electricity meter 102 connected by electrical input terminals to electrical power lines 104 (e.g., electrical power utility lines) on one side of the electricity meter 102 and by electrical output terminals to an electrical load 106 on the other side of the electricity meter 102. The electrical load 106 may be connected through a panelboard, subpanel, or load center containing one or more circuit breakers or one or more other switch devices that are electrically connected to the load side electrical output terminals of the electricity meter 102, for example.

Electrical load 106 may be provided by any electricity consuming article or appliance, such as lights, heater, refrigerator, stove, air conditioning, electric vehicle, electric storage device (e.g., one or more batteries), or other electricity-consuming device(s). The power lines 104 may include conventional single phase (e.g., A and B phase) power lines. Services amperages may range from 50A to 400A, for example. Other amperage services may be used. In other embodiments, three phase power (including A, B, and C phases) may be provided.

The electricity meter 102 has a meter housing 102H that is of a suitable size and shape and that may be appropriately configured and adapted to contain and secure the internal components of the electricity meter 102. Housing 102H may be plastic and may be injection molded. Contained and secured within the housing 102H may be a processor 108 such as an ARM microprocessor, a memory 110, a communications module 112, a sensor 114 (e.g., a current or voltage sensor), and a service disconnect/reconnect switch (hereinafter "service disconnect switch" 116) adapted to disconnect and/or reconnect electrical power to or from the load 106. The detailed function and structure of the electricity meter and various electrical power distribution systems (e.g, 100 - 700) incorporating the electricity meter 102 will be described herein below.

The electrical power distribution system 100 includes a communication and control system 117 (shown dotted), which may include a communications network 118 operable to communicate with the electricity meter 102. The communications network 118 is configured and adapted to send communication signals containing data and/or information to the electricity meter 102, and may also receive communication signals containing data and/or information from the electricity meter 102. The communication network 118 may communicate with the communications module 112 via two-way communication, both sending and receiving communication signals containing data and/or information. Communication signals that are sent may include threshold values that are sent to the electricity meter 102 and preprogrammed and stored as one or more thresholds in the memory 110 thereof. The communication signals received by the communications network 118 may be verification signals that the communication has properly taken place, for example. Communications network 118 may be made up of one or more modules or components.

Communication and control system 117 may also include a communications server 120 connected to the communications network 118 and operational and adapted to manage communication signals (e.g., packets or messages containing data and/or information) sent over the communications network 118. Communication server 120 may be a suitable computer having a processor, memory, one or more input devices, and a display device, for example.

The communication and control system 117 may also include a second computer acting as a controls server 122 for initiating control commands. The control commands initiate the sending of the communication signals containing information and/or data to be sent through the communications server 120 and communications network 118 to the electricity meter 102. The controls server 122 may be coupled to a database device 124, such as another computer server having a database configured to store information about the electricity meter 102 as well as other electricity meters installed on the power grid. The database device 124 may be large enough to contain information about thousands or even tens or hundreds of thousand s of electricity meters like electricity meter 102. The database may be configured to store and contain the one or more thresholds for electricity meter 102, as well as for other electricity meters in the grid. The one or more thresholds and/or other information stored on the database may be updated from time to time.

In particular, the database of the database device 124 may be used to store one or more thresholds (e.g., finite values) that are preprogrammed into the memory 110 of the electricity meter 102, as well as other meters on the power grid and which are used in carrying out an automatic power disconnection and/or reconnection scheme for each electricity meter on the power grid. Other information may be stored in the database, such as information and data about average power consumption, other electrical devices connected to the load side of the electricity meter 102, such as the types and approximate sizes (e.g., amperage ratings) of the electrical loads that are coupled to the electricity meter 102 and other meters, as well as their location on the power grid, their zone or area, and other information. Additional information may be stored in the database if the customer utilizes customer-site electric generator or a customer-site electric storage device, as will be explained herein below.

The disconnection and/or reconnection scheme operates, in one embodiment, to disconnect the electricity meter 102 as well as other meters from the grid. The electricity meter 102 is operable, when conditions established by the one or more thresholds are not met, to open the service disconnect switch 116 and automatically disconnect the electrical load 106.

Additionally, the scheme may reconnect various electrical meters (like electricity meter 102) to the power grid at different times. Reconnection may occur automatically when conditions established by the one or more thresholds are met. In this way, automated reconnection may be accomplished by the electricity meter 102. As one advantage, reconnection may occur in a manner that limits or eliminates damage to the electrical load 106 when conditions on the grid are not proper (e.g., voltage too low, current too high, frequency outside of one or more bounds). In particular, each electricity meter 102 on the power grid may carry out an automatic disconnection when criteria are not met, such as when an outage or other malfunction occurs, and may automatically reconnect after certain preprogrammed criteria of the electricity meter 102 are met.

The communication and control system 117 may also include a distribution management server 125 that may be coupled to the controls server 122 and may be operable to receive a status of the electrical distribution system from the distribution management server 125. The distribution management server 125 may function to override the conditions as established by the one or more thresholds and may be used to disconnect the meter 102 or other meters in the system, may limit the usage of a particular electricity meter, or may receive data from, and send control signals to, switches, capacitor banks, or other devices installed on power lines, at substations, or at transformers on the utility distribution grid.

The controls server 122 may contain suitable internal software and programming and is operable to synchronize the one or more threshold between the database of data and/or information stored in the database device 124 and the memory 110 of the various electricity meters (like electricity meter 102) contained on the power grid. The synchronization may occur by sending communication signals containing the one or more thresholds over the communications network 118 via any suitable communication protocol. This may be followed by receiving a communication signal containing affirmation information or data confirming receipt of the communication signal by the electricity meter 102. The one or more thresholds may be sent in message as one or more data packets. The communication signals may include headers, start and end characters, addresses and routing information, and the data packet as are well known. Controls server 122 may be any suitable computer having a processor, memory, one or more input peripherals, and a display that is able to carry out communication with the communications server 120, for example.

In some embodiments, the controls server 122 and database device 124 may reside in one computer. Likewise, the controls server 122 and communications server 120 may be consolidated into one computer, or the controls server 122 and distribution management server 125 may be consolidated into one computer. In one embodiment, all of the various functions of the distribution management server 125, controls server 122, communications server 120, and database device 124 may also be carried out by one computer.

Thus in operation, for each electricity meter 102, the memory 110 stores one or more thresholds (e.g., preprogrammed values) for use in disconnecting the electrical load 106 after a distribution grid outage or malfunction, and/or for reconnecting the electrical load 106 after a distribution grid outage is restored or the malfunction is corrected. In particular, power restoration may occur only after sufficient electrical parameters are sensed by the sensor 114 (e.g., by a current or voltage sensor).

For example, the service disconnect switch 116 may operate to disconnect the electrical load 106 when a measured parameter delivered by the power lines 104 fails to meet the conditions established by the one or more thresholds stored in the memory 110, and/or the service disconnect switch 116 may be operable to automatically reconnect the electrical load 106 when a measured parameter delivered by the power lines 104 meets the conditions established by the one or more thresholds stored in the memory 110, as will be apparent from the following. In one or more embodiments, the one or more thresholds may be one or more current thresholds, one or more voltage thresholds, or one or more power thresholds. In other embodiments, the one or more thresholds may be one or more frequency thresholds. Combinations of one or more frequency thresholds together with one or more current, voltage, power thresholds or other combinations may be used in some embodiments.

In some embodiments, the one or more thresholds are one or more current bounds, such as an upper current bound and a lower current bound. When a current delivered by the power lines 104 and sensed by the sensor 114 falls outside of the conditions established by the one or more current bounds stored in the memory 110, an automated disconnection is initiated via opening of the service disconnect switch 116. The sensor 114 may be a current sensor that is part of a current sensing circuit adapted to sense the current available on the input terminals on the line side of the electricity meter 120. The opening of the service disconnect switch 116 in the depicted embodiments described herein may be by operation of an actuator coupled to or part of the service disconnect switch 116. The current may be determined by a sensing circuit in the electricity meter 102 including one or more sensors 114 measuring current.

In other embodiments, the one or more thresholds can be one or more voltage thresholds, and when the measured voltage delivered by the power lines 104 and sensed by the sensor 116 falls outside of the conditions established by the one or more voltage thresholds stored in the memory 110, the automated disconnection is initiated. For example, the voltage sensor may be part of a voltage sensing circuit measuring the voltage across the terminals of the electricity meter coupled to the power lines 104. In one embodiment, the one or more thresholds may be upper and lower voltage bound values, and if the measured value falls outside the voltage bounds stored in the memory 110, the automated disconnection is initiated by opening of the service disconnect switch 116. In another embodiment, the one or more thresholds may be a single voltage value, and if the measured value drops below the voltage threshold stored in the memory 110, the automated disconnection is initiated by opening of the service disconnect switch 116. In another embodiment, the one or more thresholds comprise one or more voltage bounds, and when the voltage delivered by the power lines 104 and sensed by the sensor 114 meets the conditions set by the voltage bounds stored in the memory 110, an automated reconnection is initiated by closing the service disconnect switch 116. The voltage may be determined by a sensing circuit in the electricity meter 102 including one or more sensors 114 measuring voltage.

In other embodiments, the one or more thresholds can be one or more power thresholds, and when the measured power (e.g., or estimate thereof) delivered by the power lines 104 and sensed by one or more sensors 116 falls outside of the conditions established by the one or more power thresholds stored in the memory 110, the automated disconnection is initiated. n one embodiment, the one or more power thresholds may be upper and lower power bound values, and if the determined value falls outside the power bounds stored in the memory 110, the automated disconnection is initiated by opening of the service disconnect switch 116. In another embodiment, the one or more power thresholds may be a single power value, and if the determined value drops below a power threshold stored in the memory 110, automated disconnection is initiated by opening of the service disconnect switch 116. In another embodiment, when the power delivered by the power lines 104 and sensed by the one or more sensors 114 again meets the conditions set by the one or more power bounds stored in the memory 110, an automated reconnection may be initiated by closing the service disconnect switch 116. The power may be determined by a sensing circuit including one or more sensors 114 in the electricity meter 102 measuring both voltage and current, or via one or more sensors 114 measuring current in a circuit with known resistance.

In other embodiments, the electricity meter 102 may be operable to initiate the automatic disconnection of the electrical load 106 when a measured frequency of the power lines 104 falls outside of the conditions established by the one or more frequency thresholds stored in the memory 110. In particular, the one or more thresholds can be an upper frequency bound and a lower frequency bound, and the disconnection may be automatically initiated when the measured frequency of the current signal is above an upper frequency bound or below a lower frequency bound comprising the one or more thresholds stored in the memory 110. In another embodiment, the electricity meter 102 is operable to reconnect the electrical load 106 when a measured frequency delivered by the power lines 104 returns between an upper frequency bound and lower frequency bound comprising the one or more thresholds stored in the memory 110. The frequency may be determined by a sensing circuit in the electricity meter 102 including one or more sensors 114 measuring a period of the sinusoidal AC current or voltage, for example.

In each of the above cases, the database of the communications and controls system 117 is configured and adapted to store the one or more thresholds comprising at least one current bound, at least one voltage bound, and/or at least one frequency bound used for automatic disconnection and/or reconnection, a communications network 118 adapted to communicate with the electricity meter 102, and a controls server operational to automatically synchronize the one or more threshold values between the database and the memory 110 by sending communication signals over the communications network. The synchronization may take place as the meter is install, or whenever any update takes place.

As discussed above, the electricity meter 102 is operable to automatically disconnect and/or reconnect the electrical load 106 after sensing a distribution grid outage and subsequent restoration thereof. The service disconnect switch 116 may be first actuated to disconnect the electricity meter 102 from the power lines 106 upon sensing one or more measured parameters and comparing the measured parameters (or a value derived therefrom) to one or more conditions established by the one or more thresholds stored in memory 110. If the conditions are not met, such as due to a lack of power in the power lines 104 due to a power outage, then the service disconnect switch 116 may be opened. The service disconnect switch 116 may be suitably actuated electrical contact device having at least one moveable electrical contact. Service disconnect switch 116 may have a switch actuator that may be a solenoid or other actuator that is operable to automatically open and/or close the contacts responsive to control signals from the processor 108. In one embodiment, the service disconnect switch 116 may be, for example, a normally-opened switch, such that loss of power to a switch actuator holding the contacts closed results in opening of the service disconnect switch 116 via a spring bias or other biasing force causing the electrical contacts to separate. In other embodiments, the contacts are separated by the switch actuator being sent a signal from the processor based upon the conditions not being met. In some embodiments, a local battery or capacitor may be used in the electricity meter 102 to provide sufficient power to power the electronics and/or allow the switch actuation even if sufficient power is not present on the power lines 104. Thus, disconnection may be manual process that may take place automatically upon encountering a loss of power on the power lines 104 in some embodiments, whereas in other embodiments, the actuation may be an automatic based upon a powered actuation of an actuator switch.

Reconnection may be accomplished after sensing parameters and comparing the parameters (or values derived from the sensed parameters) to conditions established by the one or more thresholds in memory 110. If the conditions set by the one or more thresholds are met (e.g., providing sufficiently stable power on the power lines 104) then the service disconnect switch 116 may again be closed thereby connecting the electrical load 106 to the power lines 104. The actuation may be an automatic based upon a powered actuation of an actuator switch coupled to at least one of the electrical contacts of the service disconnect switch 116.

In particular, in one embodiment, the sensing may be accomplished by one or more suitable sensors 114, such as current sensor or voltage sensor and suitable sensing circuitry adapted to determine a value representative of current, voltage, power, or frequency or combinations thereof. The one or more sensors 114 may be any suitable transformer device and may comprise a coil surrounding one or more of the meter terminals connected to the power lines 104, and/or taps on the meter terminals coupled to the power lines 104. The one or more sensors may be coupled to a suitable sensing circuit. The sensing circuit may include suitable analog to digital conversion and/or amplification and/or filtering to provide a suitable digital signal that may be used by the computer processor 108.

As discussed above, current alone may be sensed, voltage alone may be sensed, or voltage and current both may be sensed in some embodiments, such as when power is determined. The one or more sensors 114 and sensing circuit may be operational to provide one or more values (either measured or derived based on the measured value(s)) and provide an output signal to the processor 108, which may be compared to one or more thresholds stored in memory 110 to determine if the conditions established by the one or more thresholds have been met. If the conditions are not met, then automatic disconnection is initiated. Likewise, if sufficient restoration of electrical power has occurred via the conditions being met in the power lines 104, automatic reconnection is initiated. For example, in one embodiment, once a current or voltage value sensed by a sensing circuit of the electricity meter 102 meets the conditions established by the one or more thresholds in memory 110 for longer than a sampling period, say 16 ms or more, then it may be determined that sufficient power is available for a safe reconnection. Once sufficient power is present, as determined by meeting the pre-programmed conditions, reconnection may take place. In one or more embodiments, reconnection may be following a time delay. The service disconnect switch 116 may be actuated to reconnect the power from power lines 104 to the electrical load 106 after the time delay has elapsed. The actuation service disconnect switch 116 may be initiated by an actuation signal received from the processor 108. An appropriate drive circuit including digital to analog (D/A) conversion and/or amplification may be provided to drive the switch actuator that is coupled to or part of the service disconnect switch 116.

In the depicted embodiments herein, the memory 110 is configured and adapted to store the one or more threshold values. Memory 110 may be any suitable type of memory, such as nonvolatile memory (e.g., Read-Only Memory (ROM)). The ROM may be electrically erasable programmable read only memory (EEPROM), flash memory, or other changeable memory.

The computer processor 108 may be any suitable processor or microprocessor that is adapted to, and capable of, receiving data in digital form from the sensor circuitry coupled to the sensor 114, executing any number of programmed instructions including calculating and determining values (e.g., power) based upon the sensed values, comparing the sensed or determined values to the one or more threshold values in memory 110, carrying out time delays, and sending actuation signals to the service disconnect switch 116 to disconnect and/or reconnect the power lines 104 from or to the electrical load 106. The computer processor 108 may be an ARM processor, such as a 32-bit reduced instruction set computer (RISC) microprocessor developed by Advanced RISC Machines, Ltd. Other microprocessors may be used.

The communication module 112 may be used to communicate with the communications network 118 of the communication and control system 117 (shown dotted). For example, in one embodiment, the communications module 112 may be a wireless communication device, such as a radio frequency (RF) device. Communication may take place at between 400 MHz and 5 GHz, for example. Other communication frequencies may be used. Moreover, other types of wireless communication may be used.

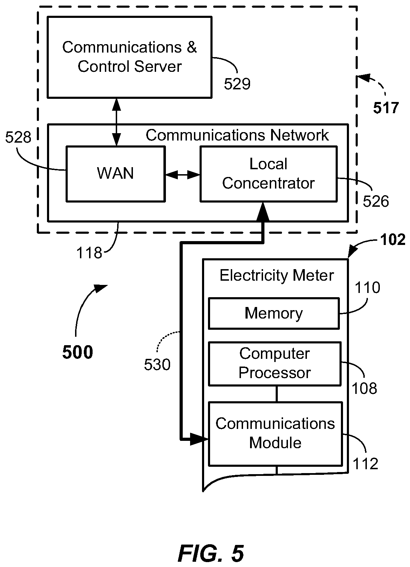

In one embodiment shown in FIG. 5, the communication module 112 may be used to communicate with the communications network 118 of a communication and control system 517 (shown dotted). For example, in some embodiments, the communications module 112 may be a ZIGBEE module adapted to wirelessly communicate with a local concentrator 526 or other node of a smart grid of a utility via wireless (e.g., RF) communication signals 530. Other wireless devices and protocols may be used, such as RF mesh. The local concentrator 326 may communicate with a wide area network (WAN) 528, which may then communicate with a communications and control server 529. Communications and control server 329 may include the functions previously-described for the communications server 120, controls server 122, and database device 124. Together, the communications module 112 and the local concentrator 526 may make up a wireless local area network (WLAN). The one or more thresholds and/or other information concerning the electricity meter 102 and/or load 106 may be communicated via any suitable WLAN and WAN.

In some embodiments, one or more individual threshold values may be communicated to each electricity meter 102 on the grid. In other embodiments, several electricity meters may receive one or more common threshold values. For example, all electricity meters in communication with a certain communication node (e.g., local concentrator 526) may receive all the same threshold information. In some embodiments, the communication signals may include time delay information as well as the thresholds. In this instance, small local parts of the power grid may be controlled in a way to carry out phased power reconnection by implementing different lengths of time delays. Accordingly, power surges may be avoided.

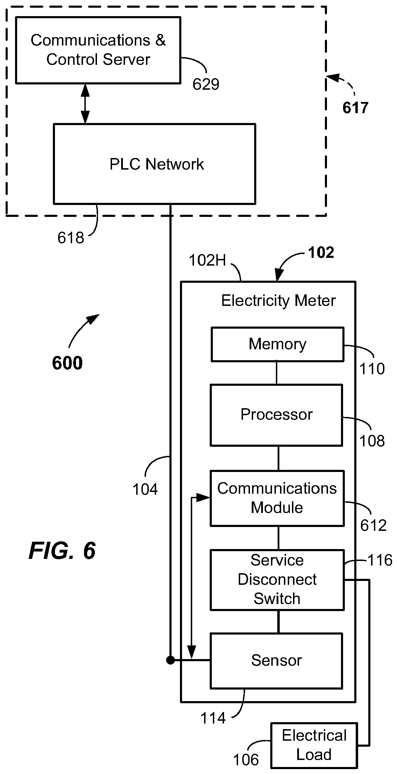

In another embodiment as shown in FIG. 6, the communication module 612 may communicate with a communication and control system 617 (shown dotted) by using a power line communication (PLC) network 618 via power line communication (PLC) where the communication signal including the one or more thresholds and/or other information provided by the communications and control server 629 is carried through a PLC network 618 and over one or more of the power lines 104. Optionally, the power line communication may be a broadband over power line (BPL).

Again referring to FIG. 1, in yet further embodiments, communication network 118 may be cellular network, where the communications module 112 may communicate with a cell tower and the communications signals and/or other information may be communicated via optical fiber through a local phone system carrier to accomplish data communication between the communications server 120 and the electricity meter 102. Other types of wired or wireless data communication protocols and systems may be used.

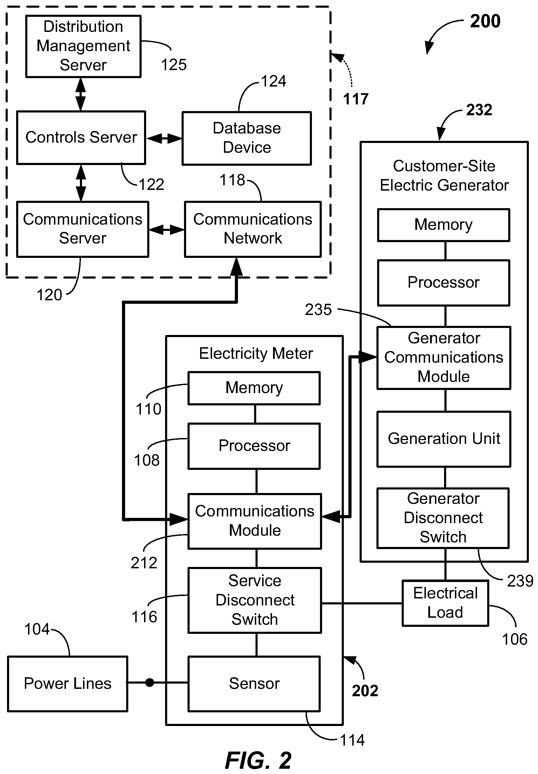

In FIG. 2, another embodiment of the invention is shown. In this embodiment, an electrical power distribution system 200 may include an electricity meter 202, similar to the electricity meter 102 previously described. The electricity meter 202 may be coupleable to a customer-site electric generator 232, and the customer-site electric generator 232 may be connectable to the electrical load 106. Accordingly, the electricity meter 202 not only communicates with the communication network 118, but also communicates with a customer-site electric generator 232. In this embodiment, the electricity meter 202 has the ability to send communication signals and/or information to the customer-site electric generator 232 and may also receive communication signals and/or information from the customer-site electric generator 232.

In one embodiment, upon sensing a power outage on the power lines 104 via any suitable schemes discussed above, such as when a current delivered by the power lines 104 and measured by the sensor 114 does not meet the established conditions that are set by the one or more thresholds stored in the memory 110, the communications module 212 of the electricity meter 202 may disconnect the utility power via opening the service disconnect switch 116, and then send a control signal (e.g., a connect control signal) to the generator communications module 235 of the customer-site electric generator 232. When suitable power is being generated by the customer-site electric generator 232, the generator disconnect switch 239 may be actuated and closed such that the customer-site electric generator 232 may now provide power to the electric load 106.

In one embodiment of the invention, the electricity meter 202 operates to automatically disconnect the customer-site electrical generator 232 and reconnect the utility power when sufficient power, as determined by meeting the pre-programmed conditions, is sensed on the power lines 104 by the electricity meter 202. The disconnect of the customer-site electrical generator 232 may occur when a current delivered by the power lines 104 and measured by the sensor 114 meets the conditions specified by the one or more threshold stored in the memory 110. To accomplish this reconnection safely, the frequency of the AC power generated by the customer-site electric generator 232 must be appropriately synchronized with the AC power delivered by the power lines 104 prior to reconnection. The synchronization, after sensing subsequent restoration of power, may be carried out by the electricity meter 202. In particular, the memory 110 may receive one or more frequency thresholds from the communications server 120. Upon the electricity meter 202 sensing that sufficient power from the distribution grid is restored (via current, voltage, or power sensing or the like), the electricity meter 202 may operate to send a disconnect control signal (e.g., containing a message or information packet) to the customer-site electric generator 232 with the frequency of the power on the distribution grid. Phase information may also be sent. The customer-site generation device 232 than adjusts its generation frequency and phase and confirms the adjustment and synchronization is with the one or more thresholds (frequency bounds and/or phase bounds) stored in the memory electricity meter 202. Upon receipt of this confirmation by the electricity meter 202, the service disconnect switch 116 is actuated to change from the disconnected state to the connected state. In this manner, if the customer-site electric generator 232 is a solar panel or wind generator, then both the customer-site electric generator 232 and the power lines 104 may power the electrical load, and to the extent that excess power is available, it may be safely fed back to the power grid. Accordingly, safe reconnection may be accomplished after a power outage and subsequent reestablishment of sufficient power on the power grid.

In more detail, the communications module 212 of the electricity meter 202 is configured to communicate with a communications module 212G of the customer-site electric generator 232 on a load side of the electricity meter 202, receive a message from the communications module 212G indicating the generator electrical frequency (fg) of an output of the customer-site electrical power generator 232, and automatically connect an electrical load 106 only when the generator electrical frequency (fg) is between an upper frequency bound (fu) and a lower frequency bound (fl) stored in the memory 110 of the electricity meter 202. For example, the upper bound may be + 5% from the frequency of the power utility grid (fpu). The lower bound may be - 5% from the frequency of the utility grid (fpu). Thus, reconnection of the electrical load 106 to the electrical lines 104 may occur via toggling the service disconnect switch 116 upon achieving a generator frequency (fg) that is +/- 5% of the frequency of the power utility grid (fpu). Other values may be used such as +/-10%, +/-15%, or more. Also, the phase of the generator phase (pg) should be within limits of the power utility grid phase (ppu). For example, the generator phase (pg) may be within about +/- 18 degrees phase from the power utility grid phase (ppu). These one or more frequency thresholds are stored in memory 110 and may be communicated via the communications network, which may be any of the communications networks discussed herein. The communications module 212G may any suitable type of module adapted to communicate with the communications module 212 of the utility meter 202. For example, the communications module 212G may be a ZIGBEE module and may communicate wirelessly via RF.

In one or more other embodiments, a connect control signal may be sent from the electricity meter 202 to the generator communications module 235 of the customer-site electrical generator 232 to connect the customer-site electrical generator 232 when a voltage delivered by the power lines 104 and measured by the sensor 114 fails to meet the conditions specified by the one or more threshold stored in the memory. After power has been restored in the power lines 104, a disconnect control signal may be sent from the electricity meter 202 to the generator communications module 235 of the customer-site electrical generator 232 to disconnect the customer-site electrical generator 232 when a voltage delivered by the power lines 104 and measured by the sensor 114 meets the conditions specified by the one or more threshold stored in the memory 110.

In yet another embodiment, the connect control signal sent from the electricity meter 202 to the generator communications module 235 of the customer-site electric generator 232 to connect the customer-site electric generator 232 may be sent when a frequency delivered by the power line 104 fails to meet conditions set by the one or more thresholds (e.g., falling below a set frequency value or falling outside of an upper or lower frequency bound stored in memory.

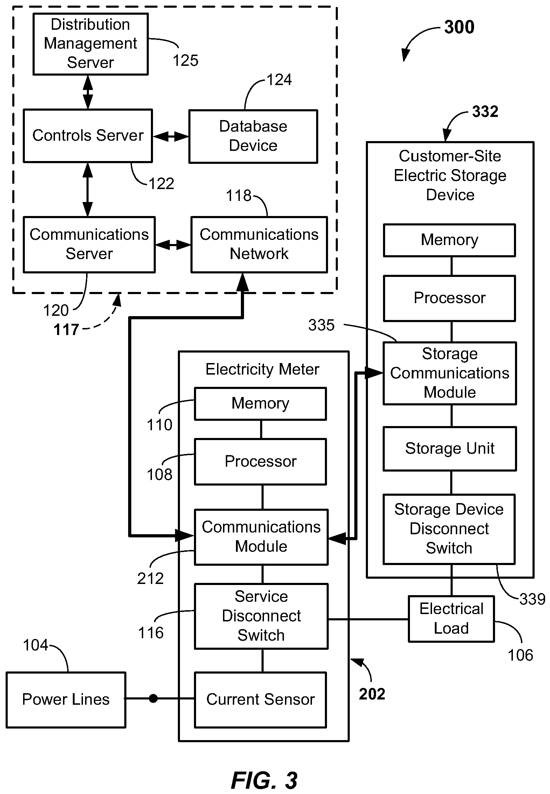

In FIG. 3, another embodiment of the invention is shown. In this embodiment, an electrical power distribution system 300 may include an electricity meter 202, similar to the electricity meter 102 previously described. The electricity meter 202 may be coupleable to a customer-site electric storage device 332, and the customer-site electric storage device 332 may be connectable to an electrical load 106. Accordingly, the electricity meter 202 not only communicates with the communication network 118, but also communicates with the customer-site electric storage device 332. In this embodiment, the electricity meter 202 has the ability to send communication signals and/or information to the customer-site electric storage device 332, and may also receive communication signals and/or information from the customer-site electric storage device 332. The customer-site electric storage device 332 may have a storage unit comprising one or more DC batteries, and may be used to provide backup power. Such one or more batteries may be contained in an electric vehicle connected to the electricity meter 202, for example. The electric vehicle may be an electrical load 106 at the customer site (e.g., end user's premises) at times, and may be used to provide backup power at the premise at other times to power other electrical loads. In this case, the storage unit may include one or more batteries and an inverter unit.

In one embodiment, upon sensing a power outage on the power lines 104 via any suitable scheme as discussed above, the communications module 212 of the electricity meter 202 may disconnect the utility power via opening the service disconnect switch 116, and then send a connect control signal to the customer-site electric storage device 332. When suitable power is being generated by the customer-site electric storage device 332, the storage device disconnect switch 339 may be actuated and closed such that the customer-site electric storage device 332 may now provide power to the electric load 106.

In one embodiment of the invention, the electricity meter 202 operates to automatically reconnect the utility power when sufficient power is sensed on the power lines 104 by the electricity meter 202. To accomplish this, the frequency of the AC power generated by the customer-site electric storage device 332 must be appropriately synchronized with the AC power delivered by the power lines 104. The synchronization after sensing subsequent restoration of power may be carried out by the electricity meter 202. In particular, the memory 110 receives the one or more frequency thresholds from the communications server 120 through the communications network 118. Upon the electricity meter 202 sensing that sufficient power from the distribution grid is restored (via current, voltage, or power sensing), the electricity meter 202 may operate to send a communication signal (e.g., containing a message or information packet) to the customer-site electric storage device 332 with the frequency of the power on the distribution grid. Phase information may also be sent. The customer-site electric storage device 332 than adjusts its generation frequency and phase and confirms the adjustment and synchronization is within the one or more thresholds (frequency bounds and/or phase bounds) stored in the memory electricity meter 202. Upon receipt of this confirmation by the electricity meter 202, the service disconnect switch 116 is actuated to change from the disconnected state to the connected state. Accordingly, safe reconnection may be accomplished after a power outage and subsequent reestablishment of sufficient power on the power grid. The communication with the communications module 335 may be identical to that disclosed with reference to the communication with the communications module 212G of the customer-site electric generator 232 FIG. 2.

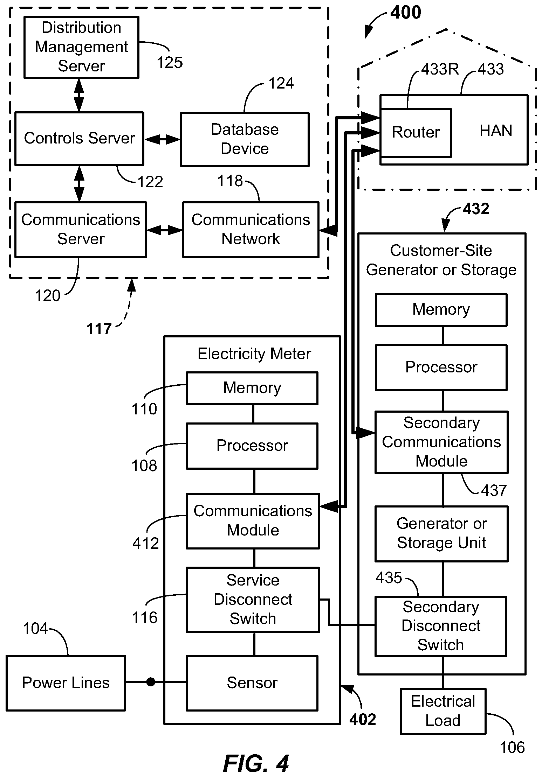

In some embodiments, as shown in FIG. 4, the communications module 412 of the electricity meter 402 may communicate with a home area network (HAN) 433 via a router 433R. In one embodiment, the router 433R may communicate with the secondary communications module 435 of the customer-site generator or storage 432 in either via any suitable local area network (LAN) such as a wired network (e.g., CAT 5e) or wirelessly via a wireless protocol and method, such as wireless personal area network (WPAN), wireless local area network (WLAN), Wi-Fi, or the like. Thus, in another aspect the communications server 120 of the communication and control system 117 may communicate with the customer-site electric generator or storage device 432 connectable to the load side of the electricity meter 402 via a communications network 118 for sending communication signals to the customer-site electric generator or storage device 432 and receiving communication signals from the customer-site electric generator or storage device 432. Information may be provided regarding the status of the customer-site electric generator or storage device 432 to the distribution management server 125, for example. Operational data may be communicated, as well.

In another embodiment, one or more threshold values may be communicated through the router 433R to the electricity meter 402. The one or more threshold values communicated through the router 433R may be an upper frequency bound (fu) and a lower frequency bound (fl) for the electricity meter 402. These values may be stored in the database device 124 of the communication and control system 117 wherein the upper frequency bound (fu) and the lower frequency (fl) bound comprising the one or more thresholds are synchronized between the electricity meter 402 and the database device 124 via communication signals (e.g., messages or packets) sent over the communications network 118 to the router 433R.

These one or more thresholds may then be communicated between the communications module 412 of the electricity meter 402 and the secondary communications module 437 of the customer-site electric generator or storage device 432. This communication may be through the router 433R or through a HAN communication module that is part of the communication module 412. Optionally, communication with the electricity meter 402 may be through a communications network 118 as shown and described in FIG. 3. In this manner, the one or more thresholds may be communicated via a local concentrator to the electricity meter 402, and then to the customer-site electric generator or storage device 432 by communication between the communications module 412 and secondary communications module 437 either via the router 433R or directly via an HAN communication, ZIGBEE communication, or the like.

In one or more embodiments, the customer-site generator or customer-site storage 432 may be connectable to the electrical load 106 via a secondary disconnect switch 435 that can disconnect or connect the electrical load 106 upon receipt of a control signal from either of the electricity meter 402, or the router 433R that is coupled to a secondary communications module 437 of the customer-site generator or customer-site storage 432. Optionally, the router 433R may only communicate with the communications module 412, and the communications module 412 may communicate with the secondary communications module 437 wirelessly, using any suitable wireless communication technology.

In other embodiments, the communication between the electricity meter 402 and the communications network 118 may be directly through a WAN. In yet further embodiments, the communication between the electricity meter 402 and the communications network 118 as well as between the customer-site generator or customer-site storage 432 and the communications network 118 may be through a WAN. The WAN may include a local WAN module that is positioned locally proximate the electricity meter 402. The local WAN module may also communicate with the router 433R in some embodiments. The router 433R may include a modem in some embodiments.

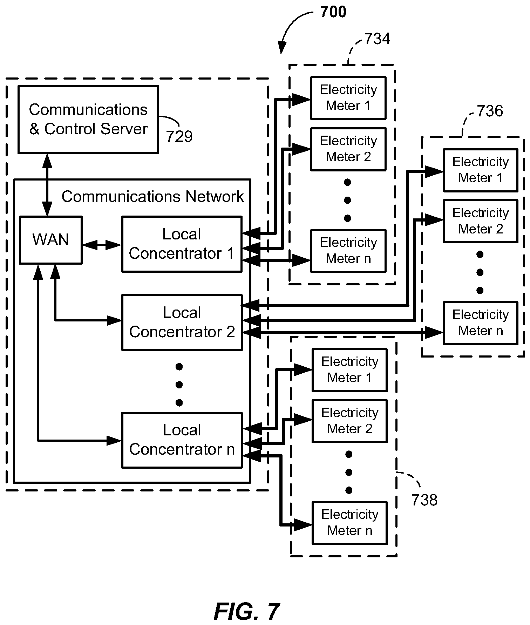

FIG. 7 illustrates an electrical power distribution system 700 according to another embodiment of the invention. In this embodiment, the system 700 includes multiple power zones 734, 736, 738. The zones 734, 736, 738 may be in different geographical areas within the overall area serviced by a power grid and may include, tens, hundreds, or even thousands of residences or power consumers per zone. Each zone may include a plurality of the electricity meters of any of the types described herein (e.g., electricity meters 102, 202, 302, and 402). For example, the first zone 734 may include electricity meters 1 through n. Zones 736 and 738 may include additional electrical meters 1 through n. Each zone may communicate with a local concentrator (e.g., local concentrators 1-n) in this embodiment. Each of the local concentrators 1-n then communicates with a WAN, which interfaces and communicates with the communications and control server 729. Communications and control server 729 may be a collection of servers in some embodiments. For example, one or more servers may carry out each of the control, communication, data storage, and distribution management functions.

Several different methodologies have been discussed herein that may be used to ensure automatic local disconnection and/or reconnection. In addition, methods of power restoration have been described enabling safe reconnection following outages. Thus, it should be apparent that local disconnection and/or reconnection may minimize the number of customer sites affected, and the sites affected may be as few as one per zone, or only so many sites as are affected by local outage conditions or malfunctions.

In another aspect, power surges upon reconnection may be avoided. In one aspect, at least some of the electricity meters 1-n for each zone 734-738 are capable of having programmable time delays may be programmed to have a different delay in each zone. Thus, looking at zone 734, some electricity meters 1 through n may be set to have a relatively longer time delays and some may be set to have a relatively shorter time delays. For example, the time delay may be a fixed time delay, such as 2, 3, 4, 5, 10, or 20 seconds. Other time delays may be used. Time delays between about 1 and about 30 seconds may be used in some embodiments. Different fixed time delays may be assigned to different electricity meters 1 through n.

In other embodiments, certain meters within a zone may share the same delay time. The delay time per zone may be selected to bring the loads of that zone onto the power grid at any suitable rate, such as in increments, linearly, or nonlinearly. For example, the use of meter time delays may be used to bring on all customer sites on line in a staged manner, i.e., within a 30 second period of time. Other periods may be used. In other embodiments, all of the electricity meters 1-n in a zone (e.g., zone 734) may share a same delay time, and the number of zones may be larger. Thus, control may be achieved by assigning each zone to have a generally different length of collective delay. Thus, the time delays may be the same in one zone (e.g., in zone 734), but different in other zones (e.g., in zones 736, 738). Accordingly a first zone (e.g., zone 734), may be brought on all at once, followed by a second zone (e.g., in zone 736), etc. Delays may be the set differently for each meter, or only for some meters. Some meters may share the same time delay. Any suitable combination may be assigned to aid in bringing on load during reconnection in a staged manner. Communication of the delay times may take place as a meter is brought into service or later on. Communication to the electricity meters 1-n may take place in a round robin fashion whereas time delay data may be sent to an electricity meter, then to the next, then to the next, and so on. Further, time delay information may be sent to zones. In each case, the time delay information may be sent via a communication (e.g., time delay value or range) and a receipt communication signal may be returned to indicate that the information was received and/or updated in memory. Error information may also be sent.

In some embodiments, where the data sent is a time range, a random number generator may be provided via software stored in the memory 110 and operated by the processor 108 to generate a delay time within the range. For example, each meter within a zone (e.g., zone 734) may be sent a single tome delay range, and then a random delay time generator may be used to generate a random time within the range. Thus, power within the zone 734 may be brought on in a random manner, but not all at once. In other embodiments, a random time generator may be used to generate a second time delay to bring the load 106 on line after the electricity meter senses that sufficient power is available via the conditions established by the one or more thresholds. Any number of schemes may be used to bring on load in any staged manner, whether based upon fixed time delays, time delay ranges, or random time delays, or combinations thereof. Delay settings for any individual electricity meters may be based upon location on the grid, location within a zone, number of meters within the zone, or the like. Delay information may be synchronized with the database in the same manner as the one or more thresholds are synchronized.

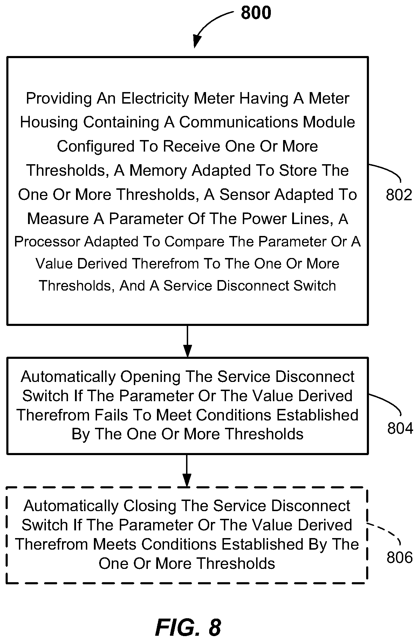

Now referring to FIG. 8, a method of controlling electricity power connection 800 according to one or more embodiments is described. The method 800 includes, in block 202, providing an electricity meter (e.g., electricity meter 102, 202, 302, 402). The electricity meter may be connected to power lines (e.g., power lines 104) on one side and an electrical load (e.g., electrical load 106) on the other side. The electricity meter having a meter housing (e.g., meter housing 102H) containing a communications module (e.g., communications module 112, 212, 312) configured to receive one or more thresholds, a memory (e.g., memory 110) adapted to store the one or more thresholds, a sensor (e.g., sensor 114) adapted to measure a measured parameter of the power lines, a processor (e.g., processor 108) adapted to compare the measured parameter or a value derived therefrom to the one or more thresholds, and a service disconnect switch (e.g., service disconnect switch 116). The method 800 includes automatically opening the service disconnect switch if the measured parameter or the value derived therefrom fails to meet conditions established by the one or more thresholds.

The one or more thresholds may be used, as discussed above, to determine when sufficient power is no longer available on the power lines 104 according to the sensed parameter (e.g., voltage, current, a power value or other combination derived from both, or a frequency value) being outside of pre-established conditions (e.g., outside of pre-established thresholds). Optionally, as shown in block 806, reconnection may be provided by automatically closing the service disconnect switch if the measured parameter or the value derived therefrom meets conditions established by the one or more thresholds. Reconnection may take place immediately after sensing sufficient power is present on the power lines 104, by may occur after a finite time delay has elapsed in some embodiments. Various electricity meters 102, 202, 302, 402, may have different time delays. Thus, load is not brought online all at once. Advantageously, one or more embodiments may provide for local automated disconnection. Accordingly, the electrical load 106 may be saved from conditions that may be damaging. Further, in another aspect, certain electrical devices comprising the electric load 106 may be protected from exposure to low voltages and/or high currents because reconnection may not be allowed until certain thresholds are met.

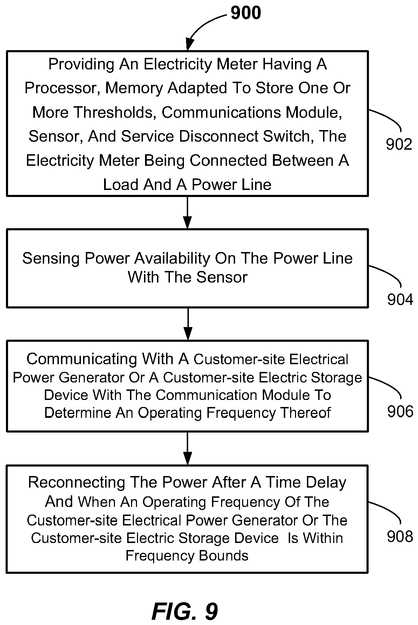

Now referring to FIG. 9, an electricity reconnection method 900 according to one or more embodiments is described. The method 900 includes, in block 902, providing an electricity meter (e.g., electricity meter 202) having a processor (e.g., processor 108), a memory (e.g., memory 110) which is adapted to store one or more thresholds, a communications module (e.g., communications module 212, 412), a sensor (e.g., sensor 114), and a service disconnect switch (e.g., service disconnect switch 116), the electricity meter (e.g., electricity meter 202, 402) being connected between a load (e.g., electrical load 106) and a power lines (e.g., power lines 104). The method 900 includes, in block 904, sensing an availability of power on the power lines. Again, sensing of sufficient power availability on the power lines 104 may be by sensing one or more parameters (e.g., current, voltage, power or other combination of both, and/or frequency). The method 900 includes in block 906, communicating with a customer-site electrical power generator (e.g., customer-site electrical power generator 232 or 432) or a customer-site electric storage device (e.g., customer-site electric storage device 332 or 432) with the communication module to determine an operating frequency (e.g., generation frequency fg)) thereof. In block 908, the power is reconnected (e.g., via actuation to close the service disconnect switch 116) when the operating frequency of the customer-site electrical power generator or the customer-site electric storage device meets conditions established by the one or more thresholds. For example, reconnection may be initiated when the operating frequency is within frequency bounds (e.g., between upper bound (fu) and lower bound (fl)) as discussed above. Reconnection should also be based on the phase of the customer-site electrical power generator or the customer-site electric storage device being within limits of the utility power phase.

While the invention is susceptible to various modifications and alternative forms, specific embodiments and methods thereof have been shown by way of example in the drawings and are described in detail herein. It should be understood, however, that it is not intended to limit the invention to the particular apparatus, systems, or methods disclosed, but, to the contrary, the intention is to cover all modifications, equivalents and alternatives falling within the scope of the invention, as defined by the appended claims.

## Claims

1. An electrical power distribution system (100, 200, 300), comprising: an electricity meter (102, 202) connected to power lines (104) on one side and an electrical load (106) on the other side, the electricity meter (102, 202) having a meter housing (102H), and a processor(108), memory (110), a communications module (112, 212), a sensor (114), and a service disconnect switch (116) within the meter housing (102H); a communication and control system (117) configured to communicate with the electricity meter (102) and operational to communicate one or more thresholds to the electricity meter (102), and wherein the electricity meter (102) is operable, when conditions established by the one or more thresholds are not met, to open the service disconnect switch (116) and automatically disconnect the electrical load (106); a customer-site electric generator (232) or electric storage device (332) connectable to the electrical load (106) via a secondary disconnect switch (239, 339) that can disconnect or reconnect the load (106) upon receipt of a control signal from the electricity meter (102) by a secondary communications module (235, 335) of the customer-site electrical generator (232) or electric storage device (332), wherein the control signal comprises a connect control signal that is sent from the electricity meter (102) to the secondary communications module (235, 335) to connect the customer-site electrical generator (232) or electric storage device (332) when a current, voltage and/ or frequency delivered by the power lines (104) and measured by the sensor (114) do not meet the established conditions that are set by the one or more thresholds stored in the memory (110) of the electricity meter (102), and wherein the control signal comprises a disconnect control signal that is sent from the electricity meter (102) to the secondary communications module (235, 335) to disconnect the customer-site electrical generator (232) or electric storage device (332) when a current, voltage and/or frequency delivered by the power lines (104) and measured by the sensor (114) meet the conditions set by the one or more threshold stored in the memory (110) of the electricity meter (102).

2. The electrical power distribution system of claim 1, wherein the communication and control system comprises:
a communications network adapted to send a communication signal to the electricity meter and receive a communication signal from the electricity meter;
a communications server connected to the communications network to manage information or data sent over the network;
a controls server for initiating control commands and other information to be sent to the electricity meter; and
a database device having a database configured to store information about the electricity meter, the database storing the one or more thresholds to be programmed into the electricity meter, and
wherein the controls server automatically synchronizes the one or more thresholds between the database and the memory of the electricity meter by initiating a sending of the communication signals over the communications network.

3. The electrical power distribution system of claim 1, wherein the service disconnect switch is operable to automatically reconnect the electrical load when a measured parameter delivered by the power lines meets the conditions established by the one or more thresholds stored in the memory.

4. The electrical power distribution system of claim 1, wherein the one or more thresholds comprises one or more current thresholds, one or more voltage thresholds, one or more power thresholds and/or one or more frequency thresholds.

5. The electrical power distribution system of claim 1, wherein the one or more thresholds comprises one or more current bounds and when a current delivered by the power lines and measured by the sensor falls outside of the conditions established by the one or more current bounds stored in the memory, the automated disconnection is initiated.

6. The electrical power distribution system of claim 1, wherein the one or more thresholds comprise a voltage threshold and when the measured voltage delivered by the power lines and sensed by the sensor drops below the voltage threshold stored in the memory, the automated disconnection is initiated.

7. The electrical power distribution system of claim 1, wherein the one or more thresholds comprises one or more voltage bounds, and when the voltage delivered by the power lines and measured by the sensor meets the conditions set by the voltage bounds stored in the memory, an automated reconnection is initiated.

8. The electrical power distribution system of claim 1, wherein the electricity meter is operable to initiate the automatic disconnection of the electrical load when a measured frequency of the power lines is above an upper frequency bound or below a lower frequency bound comprising the one or more thresholds stored in the memory.

9. The electrical power distribution system of claim 1 wherein the electricity meter is operable to reconnect the electrical load when a measured frequency delivered by the power lines returns between an upper frequency bound and lower frequency bound comprising the one or more thresholds stored in the memory.

10. The electrical power distribution system of claim 1, comprising:
a database of the communications and controls system adapted to store the one or more thresholds comprising at least one frequency bound used for automatic disconnection or reconnection,
a communications network, and
a controls server operational to automatically synchronize the one or more threshold values between the database and the memory by sending communication signals over the communications network.

11. The electrical power distribution system of claim 1, wherein the communication and controls system comprises:
a database device having a database adapted to store the one or more thresholds used for the automatic disconnection or reconnection;
a communications network; and
a controls server that is operable to automatically synchronize the one or more thresholds between the database and the memory by sending communication signals over the communications network.

12. The electrical power distribution system of claim 1, wherein a database device of the communication and control system stores information about other devices connected to the load side of the electricity meter.

13. The electrical power distribution system of claim 1, wherein a controls server of the communication and control system is operable to receive a status of the electrical distribution system from a distribution management server.

14. The electrical power distribution system of claim 1, wherein a communications server of the communication and control system communicates with the customer-site electric generator or electric storage device via a communications network for sending communication signals to and receiving communication signals from the customer-site electric generator or electric storage device.

15. An electricity meter (102, 202) connected between power lines (104) and an electrical load (106), comprising: a meter housing (102H); a communications module (112, 212) configured to receive one or more thresholds; a memory (110) adapted to store the one or more thresholds; a sensor (114) adapted to measure a parameter of the power lines; a processor (108) adapted to compare the parameter or a value derived therefrom to the one or more thresholds; and a service disconnect switch (116) automatically operable to open if the parameter or the value derived therefrom fails to meet conditions established by the one or more thresholds; wherein the communications module (112, 212) is further configured to send control signals to a secondary communications module (235, 335) comprised in a customer-site electric generator (232) or electric storage device (332), wherein the electric generator (232) or electric storage device (332) is connectable to the electrical load (106) via a secondary disconnect switch (239, 339) that can disconnect or reconnect the load (106) upon receipt of a control signal, and wherein the control signal comprises a connect control signal to connect the customer-site electrical generator (232) or electric storage (332) device when a current, voltage and/or frequency delivered by the power lines (104) and measured by the sensor (114) do not meet the established conditions that are set by the one or more thresholds stored in the memory (110), and wherein the control signal comprises a disconnect control signal to disconnect the customer-site electrical generator (232) or electric storage device (332) when a current, voltage and/or frequency delivered by the power lines (104) and measured by the sensor (114) meet the conditions set by the one or more threshold stored in the memory.

16. A method of controlling electricity power connection, comprising: providing an electricity meter (102, 202) connected between power lines (104) and an electrical load (106), the electricity meter (102, 202) comprising: a meter housing (102H), a communications module (112, 212) configured to receive one or more thresholds, a memory (110) adapted to store the one or more thresholds, a sensor (114) adapted to measure a parameter of the power lines (104), a processor (108) adapted to compare the parameter or a value derived therefrom to the one or more thresholds, and a service disconnect switch (116); and automatically opening the service disconnect switch (116) if the parameter or the value derived therefrom fails to meet conditions established by the one or more thresholds; and sending, by the communications module (112, 212), control signals to a secondary communications module (235, 335) comprised in a customer-site electric generator (232) or electric storage device (332), wherein the electric generator (232) or electric storage device (332) is connectable to the electrical load (106) via a secondary disconnect switch (239, 339) that can disconnect or reconnect the load (106) upon receipt of a control signal, and wherein the control signal comprises a connect control signal to connect the customer-site electrical generator (232) or electric storage (332) device when a current, voltage and/or frequency delivered by the power lines (104) and measured by the sensor (114) do not meet the established conditions that are set by the one or more thresholds stored in the memory (110), and wherein the control signal comprises a disconnect control signal to disconnect the customer-site electrical generator (232) or electric storage device (332) when a current, voltage and/or frequency delivered by the power lines (104) and measured by the sensor (114) meet the conditions set by the one or more threshold stored in the memory.

## Patentansprüche

1. Stromverteilungssystem (100, 200, 300), welches umfasst: einen Stromzähler (102, 202), der mit Stromleitungen (104) auf einer Seite und einer elektrischen Last (106) auf der anderen Seite verbunden ist, wobei der Stromzähler (102, 202) ein Zählergehäuse (102H) und einen Prozessor (108), einen Speicher (110), ein Kommunikationsmodul (112, 212), einen Sensor (114) und einen Service-Trennschalter (116) innerhalb des Zählergehäuses (102H) aufweist; ein Kommunikations- und Steuerungssystem (117), das dafür ausgebildet ist, mit dem Stromzähler (102) zu kommunizieren, und einsetzbar ist, um einen oder mehrere Schwellenwerte an den Stromzähler (102) zu übermitteln, und wobei der Stromzähler (102) dafür eingerichtet ist, wenn durch den einen oder die mehreren Schwellenwerte festgelegte Bedingungen nicht erfüllt sind, den Service-Trennschalter (116) zu öffnen und die elektrische Last (106) automatisch abzuschalten; einen kundenseitigen elektrischen Generator (232) oder eine kundenseitige elektrische Speichervorrichtung (332), der bzw. die mit der elektrischen Last (106) über einen sekundären Trennschalter (239, 339) verbindbar ist, welcher bei Empfang eines Steuersignals von dem Stromzähler (102) durch ein sekundäres Kommunikationsmodul (235, 335) des kundenseitigen elektrischen Generators (232) oder der kundenseitigen elektrischen Speichervorrichtung (332) die Last (106) abschalten oder wieder zuschalten kann, wobei das Steuersignal ein Verbindungs-Steuersignal umfasst, welches von dem Stromzähler (102) an das sekundäre Kommunikationsmodul (235, 335) gesendet wird, um den kundenseitigen elektrischen Generator (232) oder die kundenseitige elektrische Speichervorrichtung (332) zu verbinden, wenn ein Strom, eine Spannung und/oder eine Frequenz, die von den Stromleitungen (104) geliefert und von dem Sensor (114) gemessen werden, nicht die gestellten Bedingungen erfüllen, welche durch den einen oder die mehreren im Speicher (110) des Stromzählers (102) gespeicherten Schwellenwerte festgelegt sind, und wobei das Steuersignal ein Trenn-Steuersignal umfasst, welches von dem Stromzähler (102) an das sekundäre Kommunikationsmodul (235, 335) gesendet wird, um den kundenseitigen elektrischen Generator (232) oder die kundenseitige elektrische Speichervorrichtung (332) zu trennen, wenn ein Strom, eine Spannung und/oder eine Frequenz, die von den Stromleitungen (104) geliefert und von dem Sensor (114) gemessen werden, die Bedingungen erfüllen, welche durch den einen oder die mehreren im Speicher (110) des Stromzählers (102) gespeicherten Schwellenwerte festgelegt sind.

2. Stromverteilungssystem nach Anspruch 1, wobei das Kommunikations- und Steuerungssystem umfasst:
ein Kommunikationsnetz, das dafür ausgelegt ist, ein Kommunikationssignal an den Stromzähler zu senden und ein Kommunikationssignal von dem Stromzähler zu empfangen;
einen Kommunikationsserver, der mit dem Kommunikationsnetz verbunden ist, um Informationen oder Daten, die über das Netz gesendet werden, zu verwalten;
einen Steuerbefehlsserver zum Einleiten von Steuerbefehlen und anderen Informationen, die an den Stromzähler zu senden sind; und
eine Datenbankvorrichtung mit einer Datenbank, die dafür ausgebildet ist, Informationen über den Stromzähler zu speichern, wobei die Datenbank den einen oder die mehreren Schwellenwerte speichert, die in den Stromzähler zu programmieren sind; und
wobei der Steuerbefehlsserver automatisch den einen oder die mehreren Schwellenwerte zwischen der Datenbank und dem Speicher des Stromzählers synchronisiert, indem er ein Senden der Kommunikationssignale über das Kommunikationsnetz einleitet.

3. Stromverteilungssystem nach Anspruch 1, wobei der Service-Trennschalter dafür eingerichtet ist, die elektrische Last automatisch wieder zuzuschalten, wenn ein gemessener Parameter, der von den Stromleitungen geliefert wird, die Bedingungen erfüllt, die durch den einen oder die mehreren im Speicher gespeicherten Schwellenwerte festgelegt sind.

4. Stromverteilungssystem nach Anspruch 1, wobei der eine oder die mehreren Schwellenwerte einen oder mehrere Stromschwellenwerte, einen oder mehrere Spannungsschwellenwerte und/oder einen oder mehrere Frequenzschwellenwerte umfassen.

5. Stromverteilungssystem nach Anspruch 1, wobei der eine oder die mehreren Schwellenwerte eine oder mehrere Stromgrenzen umfassen, und wobei, wenn ein Strom, der von den Stromleitungen geliefert und von dem Sensor gemessen wird, nicht den Bedingungen genügt, die durch die eine oder die mehreren im Speicher gespeicherten Stromgrenzen festgelegt sind, die automatisierte Trennung eingeleitet wird.

6. Stromverteilungssystem nach Anspruch 1, wobei der eine oder die mehreren Schwellenwerte einen Spannungsschwellenwert umfassen, und wobei, wenn die gemessene Spannung, die von den Stromleitungen geliefert und von dem Sensor erfasst wird, unter den im Speicher gespeicherten Spannungsschwellenwert absinkt, die automatisierte Trennung eingeleitet wird.

7. Stromverteilungssystem nach Anspruch 1, wobei der eine oder die mehreren Schwellenwerte eine oder mehrere Spannungsgrenzen umfassen, und wobei, wenn die Spannung, die von den Stromleitungen geliefert und von dem Sensor gemessen wird, die Bedingungen erfüllt, die durch die im Speicher gespeicherten Spannungsgrenzen festgelegt sind, eine automatisierte erneute Zuschaltung eingeleitet wird.

8. Stromverteilungssystem nach Anspruch 1, wobei der Stromzähler dafür eingerichtet ist, die automatische Abschaltung der elektrischen Last einzuleiten, wenn eine gemessene Frequenz der Stromleitungen oberhalb einer oberen Frequenzgrenze oder unterhalb einer unteren Frequenzgrenze, welche den einen oder die mehreren im Speicher gespeicherten Schwellenwerte umfassen, liegt.

9. Stromverteilungssystem nach Anspruch 1, wobei der Stromzähler dafür eingerichtet ist, die elektrische Last wieder zuzuschalten, wenn eine gemessene Frequenz, die von den Stromleitungen geliefert wird, zwischen eine obere Frequenzgrenze und eine untere Frequenzgrenze, welche den einen oder die mehreren im Speicher gespeicherten Schwellenwerte umfassen, zurückkehrt.

10. Stromverteilungssystem nach Anspruch 1, welches umfasst:
eine Datenbank des Kommunikations- und Steuerbefehlssystems, die dazu eingerichtet ist, den einen oder die mehreren Schwellenwerte zu speichern, die wenigstens eine Frequenzgrenze umfassen, die für die automatische Abschaltung oder erneute Zuschaltung verwendet wird,
ein Kommunikationsnetz, und
einen Steuerbefehlsserver, der einsetzbar ist, um durch Senden von Kommunikationssignalen über das Kommunikationsnetz automatisch den einen oder die mehreren Schwellenwerte zwischen der Datenbank und dem Speicher zu synchronisieren.

11. Stromverteilungssystem nach Anspruch 1, wobei das Kommunikations- und Steuerbefehlssystem umfasst:
eine Datenbankvorrichtung mit einer Datenbank, die dafür ausgelegt ist, den einen oder die mehreren Schwellenwerte zu speichern, die für die automatische Abschaltung oder erneute Zuschaltung verwendet werden;
ein Kommunikationsnetz; und
einen Steuerbefehlsserver, der dafür eingerichtet ist, durch Senden von Kommunikationssignalen über das Kommunikationsnetz automatisch den einen oder die mehreren Schwellenwerte zwischen der Datenbank und dem Speicher zu synchronisieren.

12. Stromverteilungssystem nach Anspruch 1, wobei eine Datenbankvorrichtung des Kommunikations- und Steuerungssystems Informationen über andere Vorrichtungen speichert, die mit der Lastseite des Stromzählers verbunden sind.

13. Stromverteilungssystem nach Anspruch 1, wobei ein Steuerbefehlsserver des Kommunikations- und Steuerungssystems dafür eingerichtet ist, von einem Verteilungsverwaltungsserver einen Status des Stromverteilungssystems zu empfangen.

14. Stromverteilungssystem nach Anspruch 1, wobei ein Kommunikationsserver des Kommunikations- und Steuerungssystems mit dem kundenseitigen elektrischen Generator oder der kundenseitigen elektrischen Speichervorrichtung über ein Kommunikationsnetz zum Senden von Kommunikationssignalen an das und Empfangen von Kommunikationssignalen von dem kundenseitigen elektrischen Generator oder der kundenseitigen elektrischen Speichervorrichtung kommuniziert.

15. Stromzähler (102, 202), welcher zwischen Stromleitungen (104) und eine elektrische Last (106) geschaltet ist und umfasst: ein Zählergehäuse (102H); ein Kommunikationsmodul (112, 212), das dafür ausgebildet ist, einen oder mehrere Schwellenwerte zu empfangen; einen Speicher (110), der dafür ausgelegt ist, den einen oder die mehreren Schwellenwerte zu speichern; einen Sensor (114), der dafür ausgelegt ist, einen Parameter der Stromleitungen zu messen; einen Prozessor (108), der dafür ausgelegt ist, den Parameter oder einen von diesem abgeleiteten Wert mit dem einen oder den mehreren Schwellenwerten zu vergleichen; und einen Service-Trennschalter (116), der dafür eingerichtet ist, automatisch zu öffnen, falls der Parameter oder der von diesem abgeleitete Wert nicht die Bedingungen erfüllt, die durch den einen oder die mehreren Schwellenwerte festgelegt sind; wobei das Kommunikationsmodul (112, 212) ferner dafür ausgebildet ist, Steuersignale an ein sekundäres Kommunikationsmodul (235, 335) zu senden, das in einem kundenseitigen elektrischen Generator (232) oder einer kundenseitigen elektrischen Speichervorrichtung (332) enthalten ist, wobei der elektrische Generator (232) oder die elektrische Speichervorrichtung (332) mit der elektrischen Last (106) über einen sekundären Trennschalter (239, 339) verbindbar ist, welcher bei Empfang eines Steuersignals die Last (106) abschalten oder wieder zuschalten kann, und wobei das Steuersignal ein Verbindungs-Steuersignal umfasst, um den kundenseitigen elektrischen Generator (232) oder die kundenseitige elektrische Speichervorrichtung (332) zu verbinden, wenn ein Strom, eine Spannung und/oder eine Frequenz, die von den Stromleitungen (104) geliefert und von dem Sensor (114) gemessen werden, nicht die gestellten Bedingungen erfüllen, welche durch den einen oder die mehreren in dem Speicher (110) gespeicherten Schwellenwerte festgelegt sind, und wobei das Steuersignal ein Trenn-Steuersignal umfasst, um den kundenseitigen elektrischen Generator (232) oder die kundenseitige elektrische Speichervorrichtung (332) zu trennen, wenn ein Strom, eine Spannung und/oder eine Frequenz, die von den Stromleitungen (104) geliefert und von dem Sensor (114) gemessen werden, die Bedingungen erfüllen, welche durch den einen oder die mehreren in dem Speicher gespeicherten Schwellenwerte festgelegt sind.

16. Verfahren zum Steuern einer Stromverbindung, welches umfasst: Bereitstellen eines Stromzählers (102, 202), der zwischen Stromleitungen (104) und eine elektrische Last geschaltet ist, wobei der Stromzähler (102, 202) umfasst: ein Zählergehäuse (102H), ein Kommunikationsmodul (112, 212), das dafür ausgebildet ist, einen oder mehrere Schwellenwerte zu empfangen, einen Speicher (110), der dafür ausgelegt ist, den einen oder die mehreren Schwellenwerte zu speichern, einen Sensor (114), der dafür ausgelegt ist, einen Parameter der Stromleitungen (104) zu messen, einen Prozessor (108), der dafür ausgelegt ist, den Parameter oder einen von diesem abgeleiteten Wert mit dem einen oder den mehreren Schwellenwerten zu vergleichen, und einen Service-Trennschalter (116); und automatisches Öffnen des Service-Trennschalters (116), falls der Parameter oder der von diesem abgeleitete Wert nicht die Bedingungen erfüllt, die durch den einen oder die mehreren Schwellenwerte festgelegt sind; und Senden, durch das Kommunikationsmodul (112, 212), von Steuersignalen an ein sekundäres Kommunikationsmodul (235, 335), das in einem kundenseitigen elektrischen Generator (232) oder einer kundenseitigen elektrischen Speichervorrichtung (332) enthalten ist, wobei der elektrische Generator (232) oder die elektrische Speichervorrichtung (332) mit der elektrischen Last (106) über einen sekundären Trennschalter (239, 339) verbindbar ist, welcher bei Empfang eines Steuersignals die Last (106) abschalten oder wieder zuschalten kann, und wobei das Steuersignal ein Verbindungs-Steuersignal umfasst, um den kundenseitigen elektrischen Generator (232) oder die kundenseitige elektrische Speichervorrichtung (332) zu verbinden, wenn ein Strom, eine Spannung und/oder eine Frequenz, die von den Stromleitungen (104) geliefert und von dem Sensor (114) gemessen werden, nicht die gestellten Bedingungen erfüllen, welche durch den einen oder die mehreren in dem Speicher (110) gespeicherten Schwellenwerte festgelegt sind, und wobei das Steuersignal ein Trenn-Steuersignal umfasst, um den kundenseitigen elektrischen Generator (232) oder die kundenseitige elektrische Speichervorrichtung (332) zu trennen, wenn ein Strom, eine Spannung und/oder eine Frequenz, die von den Stromleitungen (104) geliefert und von dem Sensor (114) gemessen werden, die Bedingungen erfüllen, welche durch den einen oder die mehreren in dem Speicher gespeicherten Schwellenwerte festgelegt sind.

## Revendications

1. Système (100, 200, 300) de distribution d'énergie électrique, comprenant : un compteur d'électricité (102, 202) relié à des lignes électriques (104) d'un côté et à une charge électrique (106) de l'autre côté, le compteur d'électricité (102, 202) comportant un boîtier (102H) de compteur et un processeur (108), une mémoire (110), un module de télécommunications (112, 212), un détecteur (114) et un sectionneur de service (116) à l'intérieur du boîtier (102H) de compteur, un système (117) de communication et de régulation configuré en vue de communiquer avec le compteur d'électricité (102) et opérationnel en vue de communiquer un ou plusieurs seuils au compteur d'électricité (102), et étant entendu que le compteur d'électricité (102) est utilisable, quand les conditions définies par le ou les plusieurs seuils ne sont pas remplies, pour ouvrir le sectionneur de service (116) et débrancher automatiquement la charge électrique (106) ; un générateur électrique (232) sur site de client ou un dispositif (332) de stockage d'électricité sur site de client pouvant être relié à la charge électrique (106) par l'intermédiaire d'un sectionneur secondaire (239, 339) qui peut débrancher ou rebrancher la charge (106) à la réception d'un signal de commande provenant du compteur d'électricité (102), au moyen d'un module de télécommunications secondaire (235, 335) du générateur électrique (232) sur site de client ou du dispositif (332) de stockage d'électricité sur site de client, étant entendu que le signal de commande consiste en un signal de commande de branchement qui est envoyé du compteur d'électricité (102) au module de télécommunications secondaire (235, 335) pour brancher le générateur électrique (232) sur site de client ou le dispositif (332) de stockage d'électricité sur site de client quand un courant, une tension et/ou une fréquence fournis par les lignes électriques (104) et mesurés par le détecteur (114) ne répondent pas aux conditions définies qui sont fixées par le ou les plusieurs seuils stockés dans la mémoire (110) du compteur d'électricité (102), et étant entendu que le signal de commande consiste en un signal de commande de débranchement qui est envoyé du compteur d'électricité (102) au module de télécommunications secondaire (235, 335) pour débrancher le générateur électrique (232) sur site de client ou le dispositif (332) de stockage d'électricité sur site de client quand un courant, une tension et/ou une fréquence fournis par les lignes électriques (104) et mesurés par le détecteur (114) répondent aux conditions fixées par le ou les plusieurs seuils stockés dans la mémoire (110) du compteur d'électricité (102).

2. Système de distribution d'énergie électrique selon la revendication 1, étant entendu que le système de communication et de régulation comprend :
un réseau de télécommunications adapté en vue d'envoyer un signal de communication au compteur d'électricité et de recevoir un signal de communication du compteur d'électricité ;
un serveur de télécommunications relié au réseau de télécommunications afin de gérer les informations ou les données envoyées sur le réseau ;
un serveur de régulation servant à émettre des commandes de régulation et d'autres informations à envoyer au compteur d'électricité, et
un dispositif à base de données comportant une base de données configurée en vue de stocker des informations sur le compteur d'électricité, la base de données stockant le ou les plusieurs seuils à programmer dans le compteur d'électricité, et
étant entendu que le serveur de régulation synchronise automatiquement le ou les plusieurs seuils entre la base de données et la mémoire du compteur d'électricité en déclenchant l'envoi des signaux de communication sur le réseau de télécommunications.

3. Système de distribution d'énergie électrique selon la revendication 1, étant entendu que le sectionneur de service est utilisable pour rebrancher automatiquement la charge électrique quand un paramètre mesuré fourni par les lignes électriques répond aux conditions définies par le ou les plusieurs seuils stockés dans la mémoire.

4. Système de distribution d'énergie électrique selon la revendication 1, étant entendu que le ou les plusieurs seuils consistent en un ou plusieurs seuils de courant, en un ou plusieurs seuils de tension, en un ou plusieurs seuils de puissance et/ou en un ou plusieurs seuils de fréquence.

5. Système de distribution d'énergie électrique selon la revendication 1, étant entendu que le ou les plusieurs seuils consistent en une ou plusieurs limites de courant et que, lorsqu'un courant fourni par les lignes électriques et mesuré par le détecteur s'écarte des conditions définies par le ou les plusieurs limites de courant stockées dans la mémoire, le débranchement automatisé est déclenché.

6. Système de distribution d'énergie électrique selon la revendication 1, étant entendu que le ou les plusieurs seuils consistent en un seuil de tension et que, lorsque la tension mesurée fournie par les lignes électriques et détectée par le détecteur tombe sous le seuil de tension stocké dans la mémoire, le débranchement automatisé est déclenché.

7. Système de distribution d'énergie électrique selon la revendication 1, étant entendu que le ou les plusieurs seuils consistent en une ou plusieurs limites de tension et que, lorsque la tension fournie par les lignes électriques et mesurée par le détecteur répond aux conditions fixées par les limites de tension stockées dans la mémoire, un rebranchement automatisé est déclenché.

8. Système de distribution d'énergie électrique selon la revendication 1, étant entendu que le compteur d'électricité est utilisable pour déclencher le débranchement automatique de la charge électrique lorsqu'une fréquence mesurée des lignes électriques est supérieure à une limite supérieure de fréquence ou inférieure à une limite inférieure de fréquence consistant en le ou les plusieurs seuils stockés dans la mémoire.

9. Système de distribution d'énergie électrique selon la revendication 1, étant entendu que le compteur d'électricité est utilisable pour rebrancher la charge électrique lorsqu'une fréquence mesurée fournie par les lignes électriques revient entre une limite supérieure de fréquence et une limite inférieure de fréquence consistant en le ou les plusieurs seuils stockés dans la mémoire.

10. Système de distribution d'énergie électrique selon la revendication 1, comprenant :
une base de données du système de communication et de régulation adaptée en vue de stocker un ou plusieurs seuils consistant au moins en une limite de fréquence utilisée pour le débranchement ou le rebranchement automatique ;
un réseau de télécommunications, et
un serveur de régulation opérationnel en vue de synchroniser automatiquement les valeurs du ou des plusieurs seuils entre la base de données et la mémoire en envoyant des signaux de communication sur le réseau de télécommunications.

11. Système de distribution d'énergie électrique selon la revendication 1, étant entendu que le système de communication et de régulation comprend :
un dispositif à base de données comportant une base de données adaptée en vue de stocker le ou les plusieurs seuils utilisés pour le débranchement ou le rebranchement automatique ;
un réseau de télécommunications, et
un serveur de régulation qui est utilisable pour synchroniser automatiquement le ou les plusieurs seuils entre la base de données et la mémoire en envoyant des signaux de communication sur le réseau de télécommunications.

12. Système de distribution d'énergie électrique selon la revendication 1, étant entendu qu'un dispositif à base de données du système de communication et de régulation stocke des informations sur d'autres dispositifs reliés au côté charge du compteur d'électricité.

13. Système de distribution d'énergie électrique selon la revendication 1, étant entendu qu'un serveur de régulation du système de communication et de régulation est utilisable pour recevoir d'un serveur de gestion de distribution un état du système de distribution d'électricité.

14. Système de distribution d'énergie électrique selon la revendication 1, étant entendu qu'un serveur de télécommunication du système de communication et de régulation communique avec le générateur électrique sur site de client ou avec le dispositif de stockage d'électricité sur site de client par l'intermédiaire d'un réseau de télécommunications en vue d'envoyer des signaux de communication au générateur électrique sur site de client ou au dispositif de stockage d'électricité sur site de client ou d'en recevoir des signaux de communication.

15. Compteur d'électricité (102, 202) monté entre des lignes électriques (104) et une charge électrique (106), comprenant : un boîtier (102H) de compteur, un module de télécommunications (112, 212) configuré en vue de recevoir un ou plusieurs seuils, une mémoire (110) adaptée en vue de stocker le ou les plusieurs seuils, un détecteur (114) adapté en vue de mesurer un paramètre des lignes électriques, un processeur (108) adapté en vue de comparer le paramètre ou une valeur dérivée de celui-ci avec le ou les plusieurs seuils, et un sectionneur de service (116) utilisable automatiquement pour s'ouvrir si le paramètre ou la valeur dérivée de celui-ci ne répond pas aux conditions définies par le ou les plusieurs seuils, étant entendu que le module de télécommunications (112, 212) est par ailleurs configuré en vue d'envoyer des signaux de commande à un module de télécommunications secondaire (235, 335) compris dans un générateur électrique (232) sur site de client ou un dispositif (332) de stockage d'électricité sur site de client, étant entendu que le générateur électrique (232) sur site de client ou le dispositif (332) de stockage d'électricité sur site de client peut être relié à la charge électrique (106) par l'intermédiaire d'un sectionneur secondaire (239, 339) qui peut débrancher ou rebrancher la charge (106) à la réception d'un signal de commande, et étant entendu que le signal de commande consiste en un signal de commande de branchement pour brancher le générateur électrique (232) sur site de client ou le dispositif (332) de stockage d'électricité sur site de client quand un courant, une tension et/ou une fréquence fournis par les lignes électriques (104) et mesurés par le détecteur (114) ne répondent pas aux conditions définies qui sont fixées par le ou les plusieurs seuils stockés dans la mémoire (110), et étant entendu que le signal de commande consiste en un signal de commande de débranchement pour débrancher le générateur électrique (232) sur site de client ou le dispositif (332) de stockage d'électricité sur site de client quand un courant, une tension et/ou une fréquence fournis par les lignes électriques (104) et mesurés par le détecteur (114) répondent aux conditions fixées par le ou les plusieurs seuils stockés dans la mémoire.

16. Procédé de régulation du branchement d'énergie électrique, consistant : à mettre à disposition un compteur d'électricité (102, 202) monté entre des lignes électriques (104) et une charge électrique (106), le compteur d'électricité (102, 202) comprenant : un boîtier (102H) de compteur, un module de télécommunications (112, 212) configuré en vue de recevoir un ou plusieurs seuils, une mémoire (110) adaptée en vue de stocker le ou les plusieurs seuils, un détecteur (114) adapté en vue de mesurer un paramètre des lignes électriques (104), un processeur (108) adapté en vue de comparer le paramètre ou une valeur dérivée de celui-ci avec le ou les plusieurs seuils, et un sectionneur de service (116), et à ouvrir automatiquement le sectionneur de service (116) si le paramètre ou la valeur dérivée de celui-ci ne répond pas aux conditions définies par le ou les plusieurs seuils, et à faire envoyer, par le module de télécommunications (112, 212), des signaux de commande à un module de télécommunications secondaire (235, 335) compris dans un générateur électrique (232) sur site de client ou un dispositif (332) de stockage d'électricité sur site de client, étant entendu que le générateur électrique (232) ou le dispositif (332) de stockage d'électricité peut être relié à la charge électrique (106) par l'intermédiaire d'un sectionneur secondaire (239, 339) qui peut débrancher ou rebrancher la charge (106) à la réception d'un signal de commande, et étant entendu que le signal de commande consiste en un signal de commande de branchement pour brancher le générateur électrique (232) sur site de client ou le dispositif (332) de stockage d'électricité sur site de client quand un courant, une tension et/ou une fréquence fournis par les lignes électriques (104) et mesurés par le détecteur (114) ne répondent pas aux conditions définies qui sont fixées par le ou les plusieurs seuils stockés dans la mémoire (110), et étant entendu que le signal de commande consiste en un signal de commande de débranchement pour débrancher le générateur électrique (232) sur site de client ou le dispositif (332) de stockage d'électricité sur site de client quand un courant, une tension et/ou une fréquence fournis par les lignes électriques (104) et mesurés par le détecteur (114) répondent aux conditions fixées par le ou les plusieurs seuils stockés dans la mémoire.
